# EUROPÄISCHE PATENTANMELDUNG

(11) **EP 3 793 090 A1**
(43) Veröffentlichungstag der Anmeldung: **17.03.2021**
(21) Anmeldenummer: 19197084.7
(22) Anmeldetag: 12.09.2019
(51) Int. Cl.: H03K 17/74, H03J 3/20, H03J 7/08, H01G 7/00

(54) **KONDENSATOREINHEIT MIT VARIABLER KAPAZITÄT, INSBESONDERE FÜR EINE INDUKTIONSVORRICHTUNG ZUM LADEN VON KRAFTFAHRZEUGEN**

(71) Anmelder: Zollner Elektronik AG, 93499 Zandt (DE)
(72) Erfinder: Jetz, Markus, 94264 Langdorf (DE)
(74) Vertreter: Bittner, Bernhard

(57) **Zusammenfassung**

Eine Schaltungsanordnung, für eine induktive Energieübertragungsvorrichtung (50) mit einer Spuleneinrichtung (6), welche zur Ausgabe eines elektromagnetischen Feldes dient und mit einer Wechselspannungserzeugungseinrichtung (10,14a,14b), welche eine Wechselspannung erzeugt, mit der die Spuleneinrichtung (6) versorgbar ist, wobei die Schaltungsanordnung wenigstens eine Kondensatoreinheit (20) mit variabler Kapazität aufweist. Erfindungsgemäß weist die Kondensatoreinheit (20) wenigstens eine erste Kondensatoreinrichtung (22) mit variabler Kapazität (C1) und eine zweite Kondensatoreinrichtung (24) mit variabler Kapazität (C2) auf, wobei die erste Kondensatoreinrichtung (22) wenigstens zeitweise mit einer ersten Steuerspannung (U1) beaufschlagt ist und die zweite Kondensatoreinrichtung (24) wenigstens zeitweise mit einer zweiten Steuerspannung (U2) beaufschlagt ist.

## Beschreibung

Die vorliegende Erfindung bezieht sich auf eine Schaltungsanordnung, insbesondere für induktive Systeme zum Laden von Kraftfahrzeugen. Es wird jedoch darauf hingewiesen, dass die hier beschriebene Schaltungsanordnung auch in anderen technischen Bereichen Anwendung finden kann.

Im Bereich induktiver Ladesysteme ist es oftmals erforderlich, beispielsweise auf Seiten einer Ladespule, Kondensatoren mit veränderbaren Kapazitäten vorzusehen, etwa zur Abstimmung von Schwingkreisen.

Bauteile, Komponenten und Strukturen mit variabler Kapazität werden seit vielen Jahrzehnten für verschiedene Anwendungen benötigt und eingesetzt. So werden beispielsweise verstimmbare LC-Resonanzkreise beispielsweise in der Hochfrequenztechnik, Nachrichtentechnik, Radio und Fernsehtechnik, Radartechnik für unterschiedlichste Funktionen eingesetzt.

Um die LC-Resonanzkreise in ihrer Resonanzfrequenz durchzustimmen, abgleichen und anpassen zu können, kann entweder eine Spule mit der Induktivität L oder ein Kondensator mit der Kapazität C oder beide Bauelemente variabel gestaltet werden. Um Spulen bzw. Kondensatoren mit den zugehörigen L- und C-Werten zu verändern ist aus dem Stand der Technik eine hohe Anzahl an Möglichkeiten bekannt.

So kann beispielsweise eine Veränderung der Geometrie des jeweiligen Bauteils mit Hilfe einer mechanischen Schnittstelle eine Veränderung der Kapazität bewirken, beispielsweise bei einem sogenannten Dreh- oder Trimmkondensator.

Weiterhin können Serien- und Parallelumschaltungen von Bauteilen mit festen Induktivitäts- und Kapazitätswerten mit Hilfe von aktiven mechanischen elektromechanischen oder elektronischen Schaltern erreicht werden.

Weiterhin kann beispielsweise bei Spulen eine teilweise oder vollständige Sättigung des Eisenkerns mit Hilfe eines Steuergleichstroms die Induktivität verändern.

Bei Kapazitätsdioden (Varaktordioden) wird die Weite der Raumladungszone durch Anlegen einer DC-Spannung variiert, was eine Veränderung der Sperrschichtkapazität zur Folge hat.

Ein weiteres Beispiel ist ein ferroelektrischer Kondensator. Viele Materialien zeigen ein ferroelektrisches Verhalten. Werden diese Materialien als Dielektrikum zwischen zwei Kondensatorplatten verwendet, so bildet der Kondensator eine spannungsabhängige Kapazität aus.

Mit Hilfe eines aktiven Schalters kann weiterhin die Dauer der Wirksamkeit eines Kondensators oder eine Spule mit fester Kapazitäts- bzw. Induktivitätswerten in einem AC-Stromkreis eingestellt bzw. verändert werden. Dies kann beispielsweise in einer Art Phasenanschnitt- bzw. Phasenabschnittsteuerung erfolgen.

Im Bereich der Leistungselektronik werden seit vielen Jahren resonante Schaltungen genutzt. Die sogenannten Resonanzwandler bieten gegenüber den getakteten Schaltungstopologien, wie beispielsweise Buck, Boost oder Inverswandlern verschiedene Vorteile, wie beispielsweise ein sanftes Schalten der Halbleiterschalter. Daneben kann ein geringer Oberschwingungsanteil der auftretenden Ströme und Spannungen (EMI) erreicht werden. Daneben können auch große Arbeitsbereiche durch ein Ausnutzen von Resonanzüberhöhungen erreicht werden.

Weiterhin ist eine einfache galvanische Trennung durch eine Gleichstromfreiheit der Arbeitsströme möglich.

In der überwiegenden Anzahl von Anwendungen wird zur Leistungssteuerung bzw. Regelung von Resonanzwandlern ein Mix aus einer PWM (Pulsweitenmodulation) und Frequenzsteuerverfahren angewandt. Mit Hilfe der PWM wird die wirksame Amplitude der Spannung Uac(s) beeinflusst, mit welcher der passive Schaltungsteil versorgt wird. Mit Hilfe der Frequenz werden die wirksamen Impedanzen des passiven Schaltungsteils beeinflusst. Der Arbeitsstrom Iac(s) ist sowohl von der Spannung Uac(s) als auch von der Impedanz Z(s) abhängig und kann somit durch Varianz der beiden Größen beeinflusst und/oder gesteuert werden. In dem hier beschriebenen Bereich der induktiven Energieübertragung, insbesondere bei der induktiven Energieübertragung mit großen und variablen Luftspalten, treten unter Umständen große Parameterschwankungen der induktiven Übertrager auf. Sowohl die Kopplung als auch die Induktivitätswerte der Übertragerspulen können teilweise stark variieren. Bei kleinen Leistungen können diese Parameterschwankungen teilweise noch durch vergrößerte und insbesondere überdimensionierte Stellbereiche der Umrichterschaltungen kompensiert und ein Verlust im Gesamtwirkungsgrad akzeptiert werden.

Bei Geräten für den Massenmarkt ist dies jedoch auch für kleine Leistungen nicht zu empfehlen oder zu verantworten und teilweise auch nicht zulässig. Für größere Leistungen kann diese Vorgehensweise praktisch ausgeschlossen werden, da damit eine signifikante Erhöhung der benötigten Bauräume für die Elektronik und Kühlung und somit der Kosten einhergehen.

Die Anwendung eines variablen Kondensators ermöglicht die Kompensation von störenden Parameterschwankungen und erlaubt es so, ein hinsichtlich Aufbau, Wirkungsgrad und Kosten optimiertes Umrichter- und Übertragerdesign zur Verfügung zu stellen.

Bei hohen Spannungen und Strömen ergeben sich jedoch weitere Probleme. In der Leistungselektronik und im Fall von Leistungswandlern, wie Resonanzwandlern, fließen über die verwendeten Resonanzbauteile, beispielsweise den Resonanzkondensatoren, hoheAC-Ströme, welche bis in den zwei- und dreistelligen Amperebereich reichen können. Diese AC-Ströme rufen an den Resonanzbauteilen hohe AC-Spannungsabfälle hervor, die bis in den kV-Bereich reichen können. Dies ist insbesondere, aber nicht ausschließlich bei induktiven Ladesystemen im kW-Bereich mit großen Luftspalten und daher schlecht gekoppelten Spulen der Fall.

Sollen beispielsweise die Resonanzbauteile, und hier im Besonderen die Resonanzkondensatoren mit Hilfe des ferroelektrischen Effekts und einer Steuerspannung variabel ausgeführt werden, stellen die hohen AC-Spannungen ein großes Problem dar. Insbesondere soll die Kapazität des variablen Resonanzkondensators von der Steuerspannung abhängig sein.

Der vorliegenden Erfindung liegt daher die Aufgabe zugrunde einen Kondensator, welcher im Besonderen auch ein Resonanzkondensator sein kann, bzw. eine Schaltung zur Verfügung zu stellen, welche in guter Näherung lediglich eine Abhängigkeit von der Steuerspannung aufweist. Dies wird erfindungsgemäß durch die Gegenstände der unabhängigen Patentansprüche erreicht. Vorteilhafte Ausführungsformen und Weiterbildungen sind Gegenstand der Unteransprüche.

Eine erfindungsgemäße Schaltungsanordnung für eine induktive Energieübertragungsvorrichtung weist eine Spuleneinrichtung auf, welche zur Ausgabe eines elektromagnetischen Feldes dient und eine Elektrospannungserzeugungseinrichtung, welche eine Wechselspannung erzeugt, mit der die Spuleneinrichtung versorgbar ist. Dabei weist die Schaltungsanordnung wenigstens eine Kondensatoreinheit mit variabler Kapazität auf.

Erfindungsgemäß weist die Kondensatoreinheit wenigstens eine erste Kondensatoreinrichtung mit variabler und/oder spannungsabhängiger Kapazität und eine zweite Kondensatoreinrichtung mit variabler und/oder spannungsabhängiger Kapazität auf, und die Kondensatoreinrichtung wird wenigstens zeitweise mit einer ersten variablen Steuerspannung beaufschlagt und auch die zweite Kondensatoreinrichtung wird wenigstens zeitweise mit einer zweiten variablen Steuerspannung beaufschlagt.

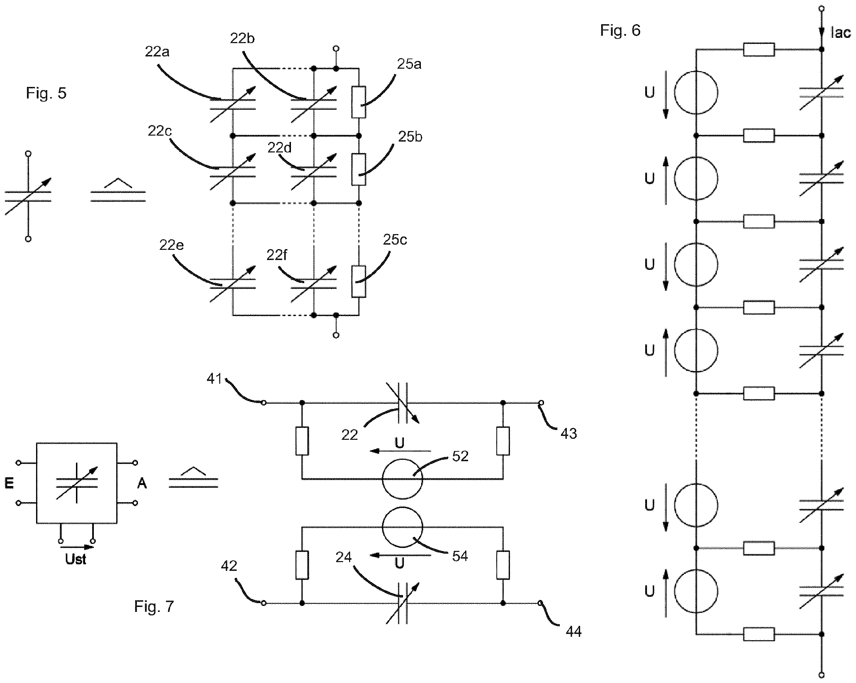

Bevorzugt handelt es sich bei der Kondensatoreinrichtung um einen spannungsabhängigen Kondensator, der in jeder Kondensatorzelle wenigstens zweimal und bevorzugt genau zweimal verwendet wird. Die Kondensatoreinrichtung kann wieder aus einer Serien- und Parallelschaltung (Fig. 5) von spannungsabhängigen Kondensatoren und sogar Ausgleichswiderständen aufgebaut sein.

Bevorzugt handelt es sich bei der Kondensatoreinrichtung um einen Resonanzkondensator, der in einen Resonanzkreis integriert ist. Es kann jedoch die Kondensatoreinrichtung auch außerhalb von Resonanzkreisen eingesetzt werden. Da, wie oben erwähnt, die Kapazität des Resonanzkondensators in guter Näherung nur von der Steuerspannung abhängig sein soll, liegt die Idee der vorliegenden Erfindung darin, dass die AC-Spannung für diesen variablen Resonanzkondensator ein Kleinsignal ist, welches den Arbeitspunkt, der mit Hilfe der Steuerspannung eingestellt wird, kaum oder nur unwesentlich ändert. Wie groß die zulässige Kapazitätsveränderung, die durch die AC-Spannung hervorgerufen wird sein darf, hängt insbesondere von der Anwendung ab.

Bevorzugt ist auch die Kondensatoreinrichtung ein elektrisches Bauteil mit spannungsabhängiger Kapazität. Die Erfindung schlägt daher vor, eine Kondensatoreinheit mit wenigstens einer ersten und einer zweiten Kondensatoreinrichtung vorzustellen, die derart geschaltet sind, dass die Kondensatoreinheit in ihrer Gesamtheit nicht oder nicht wesentlich von der Wechselspannung beeinflusst wird.

Um also die oben genannten Probleme zu vermeiden oder zu verringern, muss ein variabler Kondensator so konzipiert sein, dass dieser zusammen mit einer Steuerspannung nach außen hinsichtlich seiner Anschlussklemmen neutral ist. Hier und im Folgenden ist damit gemeint, dass bei Steuerspannungen größer Null Volt an den Klemmen der Kondensatoreinheit keine Spannung gemessen werden kann, da sich die Steuerspannungen gegenseitig aufheben.

Dies wird dadurch erreicht, dass ein variabler Kondensator bzw. die oben erwähnte Kondensatoreinheit immer wenigstens zwei Kondensatoreinrichtungen aufweist.

Bevorzugt sind die erste Kondensatoreinrichtung und die zweite Kondensatoreinrichtung in Serie geschalten.

Bei einer weiteren bevorzugten Ausführungsform sind die erste Steuerspannung und die zweite Steuerspannung gegensinnig an die beiden in Serie geschalteten Kondensatoreinrichtungen geschalten. Damit werden die beiden Kondensatoreinrichtungen gegensinnig mit Steuerspannungen versorgt. Auf diese Weise tritt die Kondensatoreinheit, welche die beiden Kondensatoreinrichtungen aufweist, insgesamt als neutrales Bauteil auf. Bevorzugt sind die erste Steuerspannung und die zweite Steuerspannung einander gegengleich. Besonders bevorzugt handelt es sich bei der ersten Steuerspannung und der zweiten Steuerspannung um eine Gleichspannung. Durch die Wahl der Steuerspannungen können die Kapazitäten der beiden Kondensatoreinrichtungen eingestellt werden.

Bei einer weiteren vorteilhaften Ausführungsform sind zwischen der/den Steuerspannung(en) und den Kondensatoreinrichtungen Widerstände geschaltet. Dabei ist es möglich, dass die Kondensatoreinrichtungen von zwei Spannungsquellen versorgt werden. Es ist jedoch auch möglich, dass lediglich eine Spannungsquelle vorgesehen ist, um die beiden Kondensatoreinrichtungen zu versorgen. Jede der Kondensatoreinrichtungen kann bevorzugt wieder aus einer Serien- und/oder Parallelschaltung von spannungsabhängigen Kondensatoren mit oder ohne Ausgleichs- bzw. Symmetrierungswiderstände aufgebaut sein.

Jede Kondensatoreinrichtung kann auch aus einer Mischung von spannungsabhängigen und spannungsunabhängigen Kondensatoren mit oder ohne Ausgleichs- bzw. Symmetrierungswiderstände aufgebaut sein.

Um diese Variante zu verwirklichen, sind in einer Ausgestaltung zwei Gleichspannungsquellen U1 und U2 vorgesehen. Die beiden Gleichspannungsquellen laden insbesondere über hochohmige Widerstände, welche auch als ohmsch induktive Impedanzen ausgeführt sein können, die variablen Kondensatoren auf ihre Gleichspannung auf. Dabei könnte die Anzahl der erforderlichen Widerstände minimiert werden.

Allerdings kann es vorteilhaft sein nicht die minimal erforderliche Anzahl von Widerständen zu verwenden, sondern die entstehenden Verluste auf mehrere Widerstände aufzuteilen. Die Ansteuerverluste, die von den Steuerspannungsquellen als Wirkleistung abgegeben werden müssen, entstehen jedoch nur solange die Kondensatoren ge- und entladen werden. Ist ein fester Arbeitspunkt bzw. eine bestimmte Kapazität eingestellt, d. h. die Kondensatoreinrichtungen auf eine bestimmte Spannung aufgeladen, müssen die Steuerspannungsquellen praktisch keine Leistung mehr abgeben (Kriech- und Leckströme werden vernachlässigt).

Daneben können auch Wechselstromverluste an den Widerständen auftreten, welche durch die Wechselspannungen über den Kondensatoreinrichtungen aufgrund des Arbeitswechselstroms lac auftreten.

Bevorzugt sind die Widerstände derart ausgelegt und bevorzugt auch gekühlt, dass sie diesen Verlustleistungen auch dauerhaft standhalten.

Bei einer weiteren bevorzugten Ausführungsform weist die Kondensatoreinheit wenigstens zwei elektrische Anschlüsse auf und wirkt hinsichtlich dieser elektrischen Anschlüsse als elektrische neutrale und insbesondere als spannungslose Einheit. Über diese beiden Anschlüsse kann die Kondensatoreinheit mit einer Wechselspannung beaufschlagt werden. Bei einer weiteren bevorzugten Ausführungsform weist die Schaltungsanordnung wenigstens eine Spannungsquelle zur Bereitstellung der Steuerspannungen auf, wobei diese wenigstens eine Spannungsquelle die Steuerspannungen bevorzugt gegengleich an die Kondensatoreinrichtungen zur Verfügung stellt.

Bei einer weiteren bevorzugten Ausführungsform weist die Schaltungsanordnung mehrere Kondensatoreinheiten mit variabler Kapazität auf. Diese können dabei miteinander verschaltet sein und insbesondere in Serie verschaltet sein. Auf diese Weise werden die benötigten Steuerspannungen auf einem akzeptablen Niveau gehalten.

Bei einer weiteren bevorzugten Ausführungsform weist jede der Kondensatoreinheiten wenigstens eine dieser zugeordneten Steuerspannungsquellen auf. Es wird jedoch in einer weiteren Ausgestaltung auch möglich, dass die Schaltungsanordnung genau eine Spannungsquelle zur Bereitstellung der Steuerspannungen aufweist.

Dabei ist es möglich, dass diese eine Steuerspannungsquelle zwei gegenläufig an den beiden Kondensatoreinrichtungen anliegende Spannungen generiert.

Bei einer weiteren bevorzugten Ausführungsform ist die Steuerspannungsquelle über einen ersten Knotenpunkt mit beiden Kondensatoreinrichtungen verbunden. Es ist möglich, dass die Steuerspannungsquelle über einen zweiten Knotenpunkt mit zwei Widerständen verbunden ist. Weiterhin ist es auch möglich, dass die Steuerspannungsquelle in einer Reihe mit einem Widerstand und einer Kondensatoreinrichtung geschaltet ist und auch in Reihe mit einem weiteren Widerstand und einer weiteren Kondensatoreinrichtung.

Bei einer weiteren bevorzugten Ausführungsform ist wenigstens eine Kondensatoreinrichtung und bevorzugt beide Kondensatoreinrichtungen aus einer Gruppe von Kondensatoreinrichtungen ausgewählt, welche Keramikkondensatoren, insbesondere X7R und X7T, Varaktordioden, Schottky-Dioden, Mosfets, Thyristoren und dergleichen enthält. Die Kondensatoreinrichtungen können aus einer Serien- und Parallelschaltung mit den genannten Bauteiltypen oder auch einer Mischung von verschiedenen Bauteiltypen aufgebaut sein.

Die vorliegende Erfindung ist weiterhin auf eine Anordnung zum induktiven Laden von Kraftfahrzeugen gerichtet, welche eine erste Schaltanordnung aufweist, welche eine Sendespule zum Ausgeben eines elektromagnetischen Feldes aufweist sowie eine zweite Schaltanordnung, welche eine Empfangsspule aufweist und das von einer Sendespule ausgegebene Signal aufzunehmen. Dabei ist die Schaltanordnung eine Schaltanordnung der oben beschriebenen Art.

Die vorliegende Erfindung ist weiterhin auf eine Kondensatoreinheit insbesondere zur Anwendung in induktiven Ladesystemen gerichtet. Dabei weist die Kondensatoreinheit wenigstens eine erste Kondensatoreinrichtung mit variabler Kapazität und eine zweite Kondensatoreinrichtung mit variabler Kapazität auf, wobei die erste Kondensatoreinrichtung wenigstens zeitweise mit einer ersten Steuerspannung beaufschlagt ist und die zweite Kondensatoreinrichtung wenigstens zeitweise mit einer zweiten Steuerspannung beaufschlagt ist, wobei die erste Kondensatoreinrichtung und die zweite Kondensatoreinrichtung in Serie geschalten sind und bevorzugt die erste Steuerspannung und die zweite Steuerspannung gleich groß und gegensinnig zueinander an den ihnen zugeordneten Kondensatoreinrichtungen angelegt sind. Es wird daher auch für die Kondensatoreinheit vorgeschlagen, dass diese selbst elektrisch neutral gegenüber weiteren Anschlüssen ist. Bevorzugt weist die Kondensatoreinheit Anschlussmittel auf, um die Kondensatoreinrichtung in einen Schaltkreis, beispielsweise einen Resonanzkreis einzubinden.

Die Erfindung ist weiterhin auf eine Schaltungsanordnung, zur Realisierung eines einstellbaren Kondensators gerichtet, wobei die Schaltungsanordnung wenigstens eine erste Kondensatoreinrichtung mit variabler Kapazität und eine zweite Kondensatoreinrichtung mit variabler Kapazität aufweist wobei die erste Kondensatoreinrichtung und die zweite Kondensatoreinrichtung wenigstens zeitweise mit einer Steuerspannung gegensinnig beaufschlagt sind. Bevorzugt ist die Schaltungsanordnung in der oben beschriebenen Weise ausgeführt.

Es wird darauf hingewiesen, dass die hier beschriebene Kondensatoreinheit bzw. die Schaltungsanordnung in unterschiedlichen technischen Bereichen Anwendung finden kann.

Die induktive Energieübertragung wie sie beispielsweise bei Fahrzeugladern verwendet werden kann, und welche hier beschrieben ist, stellt einen Spezialfall eines allgemeineren Resonanzwandlers dar. Aber auch Resonanzwandler sind nur ein möglicher Anwendungsbereich für den variablen Kondensator.

Sowohl für klassische Resonanzwandler als auch für welche die für die induktive Energieübertragung mittels magnetischer Nahfeldkopplung verwendet werden, gibt es eine große Anzahl möglicher Schaltungstopologien.

Im Rahmen der vorliegenden Erfindung wird daher vorgeschlagen eine Kondensatorzelle (Kondensatoreinheit) aufzubauen, die ein von außen gesehen elektrisch neutrales Element bildet. Dies ermöglicht praktisch einen beliebigen Einsatz des variablen Kondensators (beispielsweise in der Leistungselektronik, der Messtechnik und der Nachrichtentechnik, ...).

Ein zweites entscheidendes Merkmal ist, dass durch diese Neutralität der Kondensatorzelle bzw. Kondensatoreinheit, eine beliebige Serien- und Parallelschaltung der Kondensatorzellen (Kondensatoreinheiten) möglich ist. Dadurch entsteht ein maximierter Freiheitsgrad sowohl bei der Dimensionierung eines variablen Kondensators, der sich aus vielen Kondensatorzellen (Kondensatoreinheiten) aufbauen kann, als auch bei der Dimensionierung der Kondensatorzelle an sich.

Die vorliegende Erfindung ist weiterhin auf ein Verfahren zum Betreiben einer induktiven Energieübertragungsanordnung gerichtet, wobei mittels einer Sendespule auf eine Empfangsspule elektrische Energie übertragen wird und wobei eine Schaltungsanordnung mit einem Spannungssignal, insbesondere einem Steuersignal, beaufschlagt wird, um die Sendespule mit einer Wechselspannung zu beaufschlagen. Weiterhin wird die der Sendespule zugeführte Wechselspannung mittels wenigstens einer Kondensatoreinheit gesteuert bzw. von dieser beeinflusst, wobei die Kapazität dieser Kondensatoreinheit verändert wird. Erfindungsgemäß weist diese Kondensatoreinheit wenigstens eine erste Kondensatoreinrichtung mit einer veränderbaren Kapazität und eine zweite Kondensatoreinrichtung mit einer veränderbaren Kapazität auf, und die erste Kondensatoreinrichtung wird mit einer ersten Steuerspannung beaufschlagt und die zweite Kondensatoreinrichtung wird mit einer zweiten Steuerspannung beaufschlagt. Es wird daher auch verfahrensseitig vorgeschlagen, eine bezüglich äußerer Spannung neutrale Kondensatoreinheit zur Verfügung zu stellen.

Bei einem weiteren bevorzugten Verfahren sind die erste Kondensatoreinrichtung und die zweite Kondensatoreinrichtung in Serie geschalten.

Bei einer weiteren bevorzugten Ausführungsform werden die erste Kondensatoreinrichtung und die zweite Kondensatoreinrichtung gegensinnig mit den Steuerspannungen beaufschlagt. Damit erfolgt die Beaufschlagung bevorzugt derart, dass die Kondensatoreinheit in ihrer Gesamtheit innerhalb der Schaltungsanordnung als elektrisch neutrales Bauteil fungiert.

Es wird weiterhin ein Verfahren zum Betreiben einer Kondensatoreinheit vorgeschlagen wobei die Kapazität dieser Kondensatoreinheit verändert wird. Erfindungsgemäß weist diese Kondensatoreinheit wenigstens eine erste Kondensatoreinrichtung mit einer veränderbaren Kapazität und eine zweite Kondensatoreinrichtung mit einer veränderbaren Kapazität auf, und die erste Kondensatoreinrichtung wird mit einer ersten Steuerspannung beaufschlagt und die zweite Kondensatoreinrichtung wird mit einer zweiten Steuerspannung beaufschlagt, insbesondere derart, dass die Kondensatoreinheit eine bezüglich äußerer Spannung neutrale Einheit ausbildet. Es wird daher auch verfahrensseitig vorgeschlagen, eine bezüglich äußerer Spannung neutrale Kondensatoreinheit zur Verfügung zu stellen.

Weitere Vorteile und Ausführungsformen ergeben sich aus den beigefügten Zeichnungen.

Darin zeigen:
- Fig. 1: eine beispielhafte Darstellung einer Halbbrücken-Serienresonanzwandlereinrichtung mit einem idealisierten vereinfachten Ersatzschaltbild;
- Fig. 2a: ein typischer Verlauf zweier Spannungen an einem variablen Kondensator;
- Fig. 2b: ein typischer Verlauf einer Kapazität in Abhängigkeit der Spannung am Kondensator;
- Fig. 2c: ein typischer Ausschnitt aus einer Hystereseschleife eines ferroelektrischen Dieleketrikums mit den Minor Loops;
- Fig. 3a: eine Serienresonanzwandlereinrichtung;
- Fig. 3b: eine Parallelresonanzwandlereinrichtung;
- Fig. 4a, 4b: eine erste Variante einer Kondensatoreinheit; als Blockschaltbild mit zwei Klemmen für den Arbeitswechselstrom und einem mit zwei Klemmen angedeuteten Steuereingang (Ust) und ein zugehöriges hinsichtlich der Steuerspannungserzeugung vereinfachtes Schaltbild;
- Fig. 5: ein spannungsabhängiger Kondensator, der wiederum aus einer Serienund/oder Parallelschaltung von Kondensatoreinrichtungen mit Ausgleichswiderständen aufgebaut ist;
- Fig. 6: eine Serienschaltung von n Kondensatoreinheiten der ersten Variante mit jeweils zwei Steuerspannungsquellen pro Kondensatoreinheit, wobei die abwechselnden Polaritäten der Spannungsquellen eine ungünstige Addition der Spannungen vermeiden;
- Fig. 7: ein Blockschaltbild einer weiteren Kondensatorzelle mit vier Anschlussklemmen für den Arbeitswechselstrom und einem mit zwei Klemmen angedeuteten Steuereingang (Ust) und ein zugehöriges hinsichtlich der Steuerspannungserzeugung vereinfachtes Schaltbild;
- Fig. 8: eine Kondensatoreinheit wie in Fig. 7 in einem Probestromkreis, wobei sich die Steuergleichspannungen aus der Maschengleichung Uq - U - UA + U = 0 herauskürzen;
- Fig. 9a, 9b: eine vereinfachte Kondensatoreinheit in einer ersten Ausgestaltung; Blockschaltbild wie in Fig. 7 und zugehöriges hinsichtlich der Steuerspannungserzeugung vereinfachtes Schaltbild;
- Fig. 9c: eine Kondensatoreinheit wie in Fig. 9b in einem Probestromkreis, wobei auch hier die Steuergleichspannung am Eingang E und am Ausgang A wirkungslos ist;
- Fig. 10a: eine Serienschaltung von n Kondensatoreinheiten wie in Fig. 7, wobei die abwechselnden Polaritäten der Spannungsquellen eine ungünstige Addition der Spannungen vermeiden;
- Fig. 10b: eine Serienschaltung von n Kondensatoreinheiten wie in Fig. 9b, wobei die abwechselnden Polaritäten der Spannungsquellen eine ungünstige Addition der Spannungen vermeiden;
- Fig. 11: eine Kondensatoreinheit in einer weiteren Ausführungsform; Blockschaltbild einer Kondensatorzelle mit zwei Anschlussklemmen für den Arbeitswechselstrom und einem mit zwei Klemmen angedeuteten Steuereingang (Ust) und ein zugehöriges hinsichtlich der Steuerspannungserzeugung vereinfachtes Schaltbild;
- Fig. 12: eine Serienschaltung von N Kondensatoreinheithen der Variante von Fig. 11, wobei die abwechselnden Polaritäten der Spannungsquellen eine ungünstige Addition der Spannungen vermeiden;
- Fig. 13: vier verschiedene Möglichkeiten des Aufbaus der Kondensatoreinrichtungen einer Kondensatoreinheit in einer bevorzugten Ausführungsform.

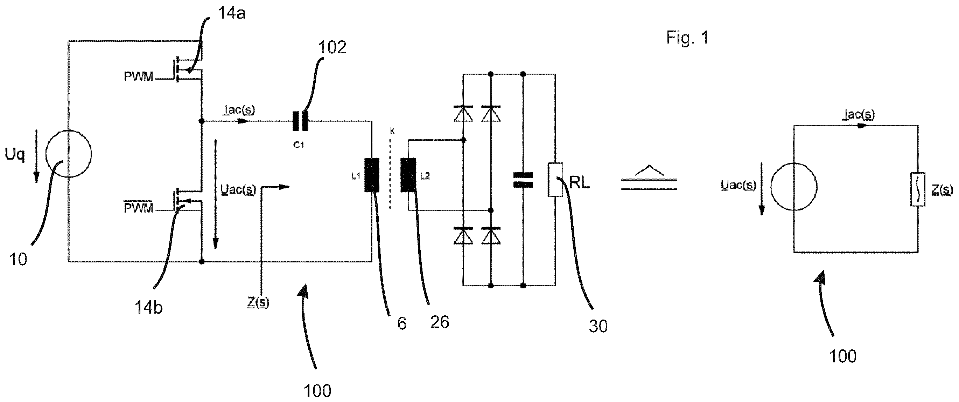

Figur 1 zeigt die Zusammenhänge zwischen einem Arbeitsstrom Iac(s) und einer Impedanz Z(s) am Beispiel eines Halbbrücken-Serienresonanzwandlers 100. Diese Schaltung weist zwei Schalteinrichtungen 14a und 14b auf. Diese Schalteinrichtungen werden bevorzugt mit eine pulsweitenmodulierten (PWM) Reckteck-Signal mit variabler Taktfrequenz angesteuert. Das Bezugszeichen Iac(s) kennzeichnet einen Arbeitsstrom, der sowohl von der Spannung Uac(s) als auch von der Impedanz Z(s) abhängig ist. Das Bezugszeichen 30 kennzeichnet eine Last RL und Bezugszeichen 6 und 26 zwei gekoppelte Spulen zur induktiven Energieübertragung. Diese gekoppelten Spulen können räumlich separiert, oder auch als diskreter Transformator ausgeführt sein.

Das Bezugszeichen 102 kennzeichnet einen Kondensator mit der Kapazität C1. Das Bezugszeichen 10 kennzeichnet eine anliegende Spannung, die durch eine Spannungsquelle Uq zur Verfügung gestellt wird.

Die PWM-Ansteuerung mit variabler Taktfrequenz weist jedoch Nachteile auf. Zum einen werden durch ein PWM-Tastverhältnis ungleich 0,5 zusätzliche Verzerrungen (Stromoberschwingungen) im Strom Iac(s) generiert und die Halbleiter unsymmetrisch belastet. Auch wirkt sich eine variable Taktfrequenz negativ auf das Design, beispielsweise von EMV-Filtern aus, indem es dieses verkompliziert.

Auch das bei hohen Leistungen vorteilhafte Parallelschalten von beispielsweise gleichartigen Wandlern und auch die phasenversetzte (Interleaved) Ansteuerung der Halbleitersätze wird bei diesem Verfahren erschwert, da Bauteiltoleranzen dazu führen, dass die Resonanzfrequenzen der parallel geschalteten Wandler an unterschiedlichen Stellen liegen.

Die Kontrolle des Arbeitswechselstroms Iac(s) durch eine aktive Veränderung der Impedanz Z(s), zum Beispiel mit Hilfe eines variablen Kondensators, ermöglicht innerhalb gewisser endlicher Stellbereiche sowohl ein konstantes PWM-Tastverhältnis von 0,5 als auch eine konstante Taktfrequenz. Dies ermöglicht eine relativ einfache Parallelschaltung mehrerer Wandler und ermöglicht so die Vorteile eines Interleaved-Betriebs. Auch die oben genannten Nachteile durch variable Taktfrequenz und PMW-Tastverhältnissen ungleich 0,5 können dadurch minimiert oder ganz vermieden werden.

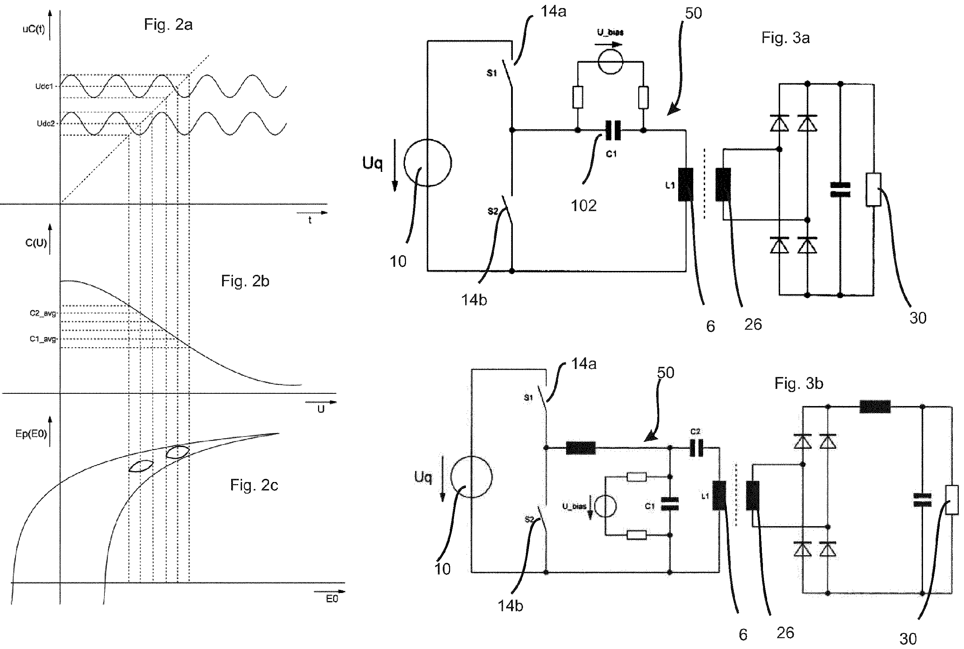

Die Figuren 2a bis 2c zeigen in einem Diagramm mögliche Zeitverläufe der Spannung uC(t) an einem variablen Kondensator. Beide Spannungsverläufe sind dabei sinusförmig mit einer jeweils anderen DC-Vorspannung Udc1 und Udc2.

Das Diagramm in Figur 2b zeigt den von den Herstellern von Keramikkondensatoren der Klasse 2 oft angegebenen typischen Kapazitätsverlauf C(U) eines Kondensators in Abhängigkeit einer Spannung U.

In Figur 2c ist schließlich ein Ausschnitt einer möglichen Hysteresekurve eines ferroelektrischen Dielektrikums dargestellt. Ein derartiges ferroelektrisches Dielektrikum wird vorteilhaft für die hier beschriebenen Kondensatoreinrichtungen verwendet. Aufgrund der Polarisation des ferroelektrischen Dielektrikums kann bei den Klasse 2 Dielektrika (z. B. X7R-Material) ein hohes εr erreicht werden.

Da die Ladungen jedoch fest an die Atome und Moleküle gebunden sind (es handelt sich um einen Isolator), kann die Polarisationsfeldstärke EP im Inneren des Dielektrikums nur bis zu einem gewissen Wert ansteigen und das externe elektrische Feld E0 kompensieren. Dabei ergibt sich ein Sättigungseffekt.

Wie bei der magnetischen Ansteuerung von zum Beispiel Weicheisenwerkstoffen mit Wechselstrom bzw. Wechselmagnetfeldern führt auch das elektrische Ansteuern von polarisierbaren Dielektrikas mit Wechselspannung bzw. elektrischen Wechselfeldern zu Verlusten. Ein Maß für diese Verluste ist ebenfalls analog zu den Magnetwerkstoffen, die durch die Hysteresekurve umschlossene Fläche.

Im Folgenden soll nun gelten, dass der Spitze-Spitze-Wert der sinusförmigen Wechselspannungen hervorgerufen durch die durch den Kondensator fließenden Wechselströme im Vergleich zur angelegten DC-Spannung klein und somit vernachlässigbar ist. Mit Hilfe einer 45°-Spiegelprojektion der Spannungswerte Udc1 und Udc2 in Figur 2a können jetzt die zugehörigen (mittleren) Kapazitätswerte C1_avg und C2_avg graphisch ermittelt werden. In Figur 2c sind die zugehörigen sogenannten Minor Loops eingezeichnet, wobei deren Flächeninhalt ein Maß für die auftretenden Polarisierungsverluste darstellt.

Um die Strom- und Spannungsbelastung der verwendeten Kondensatoren, sowie die auftretende Verlustleistung innerhalb zulässiger Bereiche zu halten, können zum Beispiel für Resonanzwandler-Anwendungen in der Regel mehrere Einzelkondensatoren in Serie und/oder parallel verschaltet werden.

Da der Einfluss der Wechselströme bzw. Wechselspannungen auf die Kapazität auch wegen möglicher Stromverzerrungen möglichst gering gehalten werden sollte, ist unter Umständen eine weitere Erhöhung der Anzahl der seriell und parallel verschaltenden Einzelkondensatoren nötig.

Die unter Umständen benötigte hohe Anzahl von seriell verschalteten Kondensatoreinrichtungen erfordert jedoch ebenfalls eine steigende DC-Spannung, um eine gewünschte Kapazitätsänderung am Gesamtkondensator hervorzurufen. Diese hohe DC-Spannung, die über den Klemmen der Kondensatoreinheit angelegt wird, wirkt unter Umständen auch auf andere Schaltungsteile zurück, welche ebenfalls eine galvanische Verbindung mit den Klemmpotenzialen des Kondensators aufweisen.

Die Figuren 3a und 3b zeigen aus dem Stand der Technik bekannte Topologien für Resonanzwandler, wobei Figur 3a einen Serienresonanzwandler und Figur 3b einen Parallelresonanzwandler zeigt. Der wesentliche Unterschied liegt hier in der Anordnung der Kapazität C1 bzw. der Kondensatoreinrichtung 102. In beiden Resonanzwandlern soll 102 als Kondensator mit variabler Kapazität C1 gelten. Die Kapazität C1 soll mit Hilfe der DC-Spannungsquelle, welche die Spannung U_bias zur Verfügung stellt, eingestellt werden. Der Wechselspannungsanteil wird als vernachlässigbar zum Gleichspannungsanteil der Kondensatorspannung angenommen. Das Bezugszeichen 50 kennzeichnet eine induktive Energieübertragungsvorrichtung in ihrer Gesamtheit.

Es ergibt sich, dass bei dem Serienresonanzwandler (Figur 3a) die Quelle U_bias auch nach dem Laden des Kondensators C1 einen Stromfluss entweder über den Schalter 14a (S1) oder den Schalter 14b (S2) sowie die Spule L1 anregt bzw. ermöglicht. Sind die Schalteinrichtungen 14a, 14b ausgeschaltet, liegt über dem Schalter 14b die gesamte Spannung, U_bias an und über dem Schalter 14a die Spannung Uq - U_bias.

Dies würde zu einem bei hohen Werten für U_bias eine unzulässige Spannungsbelastung an den Schalteinrichtungen 14a und 14b zur Folge haben und auch das Einstellen der gewünschten DC-Spannung an der Kondensatoreinrichtung 102 erschweren oder gar verhindern. Ein ähnlicher Fall mit den gleichen Problemen entsteht bei dem in Figur 3b dargestellten Parallelresonanzwandler.

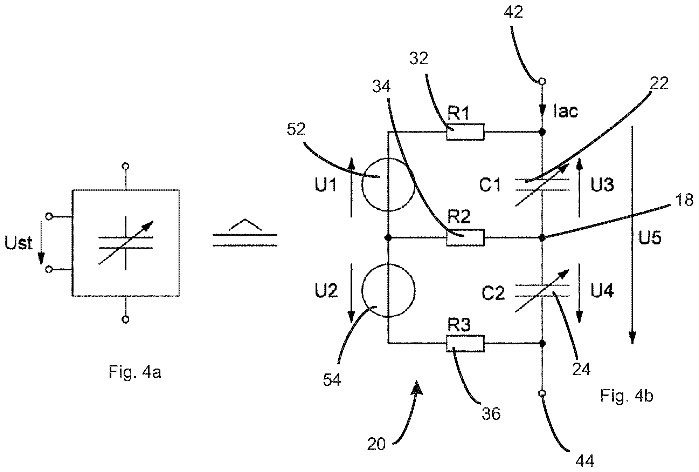

Die Figuren 4a und 4b zeigen Darstellungen einer ersten Ausführungsform einer erfindungsgemäßen Schaltungsanordnung. Die Figur 4a zeigt ein Blockschaltbild mit zwei Klemmen für den Arbeitsstrom und einem Steuereingang (Ust). Dabei können die gezeigten Kondensatoreinrichtungen 22, 24 (Kapazitäten C1 und C2) wiederum aus einer Serien- und/oder Parallelschaltung von spannungsabhängigen Kondensatoren bzw. den oben genannten Bauteilen mit spannungsabhängiger Kapazität aufgebaut sein. Auch eine Mischung von spannungsabhängigen und spannungsunhabhängigen Kondensatoren für den Aufbau einer Kondensatoreinrichtung ist denkbar. Die Bezugszeichen 52 und 54 kennzeichnen zwei Spannungsquellen, welche die Spannungen U1 und U2 zur Verfügung stellen.

Diese beiden Gleichspannungsquellen 52 und 54 laden über die hochohmigen Widerstände 32, 34 und 36, welche auch als ohmsch induktive Impedanzen ausgeführt sein können, die Kondensatoreinrichtungen 22, 24 (Kapazitäten C1 und C2) auf ihre Gleichspannung auf. Die Bezugszeichen 42 und 44 kennzeichnen Anschlussklemmen für den Arbeitsstrom für die insgesamt in Figur 4b gezeigte Kondensatoreinheit 20.

Es könnte auch der Widerstand 34 kurzgeschlossen werden. Allerdings ist es in der Praxis manchmal einfacher, die entstehenden Verluste auf mehrere Widerstände aufzuteilen und deshalb u. U. sinnvoll den Widerstand 34 beizubehalten. Die Ansteuerverluste, die von den Spannungsquellen 52 und 54 als Wirkleistung abgegeben werden müssen, entstehen jedoch nur solange die Kondensatoren ge- und entladen werden.

Dazu kommen noch Wechselstromverluste an den Widerständen, die durch die Wechselspannungen über die Kondensatoren aufgrund des Arbeitswechselstroms lac hervorgerufen werden. Die Widerstände 32, 34, 36 bilden zusammen mit den variablen Kondensatoren C1 und C2 eine Zeitkonstante τ aus. Diese Zeitkonstante bestimmt, wie schnell die Gleichspannung an den variablen Kapazitäten C1 und C2 und damit auch deren wirksame Kapazität verändert werden kann.

Die Impedanzverhältnisse bzw. Widerstandswerte werden bevorzugt derart gewählt, dass die gewünschte Änderungsgeschwindigkeit für die variable Kapazität erreicht und die akzeptable Verlustleistung an den ohmschen Widerständen nicht überschritten wird.

Sollten zum Beispiel hohe Änderungsgeschwindigkeiten für die variable Kapazität erreicht werden, kann es sinnvoll sein, die Widerstände durch Induktivitäten zu ersetzen oder zu ergänzen, welche für die Frequenz des Stromes lac sehr hochohmig sind, jedoch eine schnellere Änderung der Gleichspannung ermöglichen, als dies mit rein ohmschen Widerständen möglich wäre.

Zunächst soll kein hochfrequenter Wechselstrom Iac in die Kondensatoreinheit der Figur 4b fließen. Nach dem Anlegen der Gleichspannung U1 und U2 werden die Kondensatoren 22, 24 mit Gleichstrom aufgeladen. Nach diesem Einschwingvorgang gilt U3 = U1 und U4 = U2. Die an den Klemmen 42 und 44 anliegende Spannung U5 verschwindet, wenn die Beträge der Gleichspannungen U1 und U2 und damit auch U3 und U4 gleich sind.

Aus praktischer Sicht taucht hier ein Nachteil der Anordnung der Kondensatoreinheit nach der oben beschriebenen Variante auf, da es in der Realität entweder mit hohem Aufwand verbunden ist, die beiden Spannungen U1 und U2 zu erzeugen und aufeinander abzugleichen, oder immer eine Ungleichheit der Spannungen U1 und U2 vorliegt, welche zu einer Gleichspannung U5 an den Klemmen 42, 44 der Kondensatoreinheit führt. Untenstehend wird eine Variante aufgezeigt, die dieses Problem verhindert.

Fließt ein hochfrequenter Wechselstrom lac durch die Kondensatoreinheit, sollen die Impedanzen der variablen Kondensatoren bzw. der Kapazitäten C1 und C2 bei der Frequenz des Arbeitswechselstroms sehr viel geringer sein als die Widerstände R1 bis R3 der Widerstände 32, 34 und 36. Damit fließt in guter Näherung der gesamte Strom lac durch die Kondensatoreinrichungen C1 und C2.

Der Strom lac ruft an den Kondensatoreinrichtungen C1 und C2 eine Wechselspannung hervor, die sich der anliegenden Gleichspannung überlagert. Auch diese Wechselspannung ruft eine Änderung der Kapazität des variablen Kondensators hervor.

Dabei sollte diese Änderung durch die geeignete Dimensionierung klein gehalten werden, um einerseits die Steuerung der Kapazität ausschließlich mit Hilfe der Gleichspannung zu ermöglichen und andererseits keine Störungen und Verzerrungen der Signale, die durch eine zusätzliche Modulation der Kapazität entstehen können, hervorzurufen.

Figur 4a zeigt ein Blockschaltbild mit zwei Klemmen für den Arbeitswechselstrom und einem Steuereingang (Ust) der in Figur 4b gezeigten Anordnung.

Figur 5 zeigt die Darstellung, um zu veranschaulichen, dass ein spannungsabhängiger Kondensator sich auch aus einer Serien- und/oder Parallelschaltung von Kondensatoren mit Ausgleichswiderständen zusammensetzen kann. Auch können den spannungsabhängigen Einzelkondensatoren Ausgleichswiderstände parallel geschalten sein, um eine symmetrische Aufteilung der Gleichspannungen sicherzustellen.

In diesem Fall sollte darauf geachtet werden, dass diese Ausgleichswiderstände (25a, 25b, 25c) die Gleichspannungsquellen belasten und zum Beispiel mit den Widerständen, 32, 34, 36 aus Figur 4b Spannungsteiler bilden.

Dies kann dazu führen, dass U3 < U1 wird und U4 < U2. Um gleiche Werte von U3 und U4 einstellen zu können, wie im Fall ohne Ausgleichswiderstände, sind bevorzugt die Spannungsquellen U1 und U2 in der Lage, eine höhere Spannung und auch eine höhere Momentan- und Dauerleistung abzugeben.

Figur 6 zeigt eine Serienschaltung von Kondensatoreinrichtungen nach Figur 4b. Im Falle der Anwendung der Kondensatoreinheit für einen Resonanzwandler für eine induktive Energieübertragung hoher Leistungen, beispielsweise im kW-Bereich, kann lac Werte im zwei- oder sogar dreistelligen Amperebereich annehmen. Dies kann zu Wechselspannungen im kV-Bereich über der Kondensatoreinheit führen. Um die gewünschten Eigenschaften des steuerbaren Kondensators zu erhalten darf die Wechselspannung weiterhin nur als Kleinsignal der Steuergleichspannung am Kondensator überlagert sein.

Dies führt z. B. bei der Anwendung einer einzelnen Kondensatoreinheit zu extrem hohen (bis > 10kV) Steuergleichspannungen, die viele Probleme, wie beispielsweise Kriechstrombildung, Koronaentladung und Whiskerbildung verursachen können. Auch die Erzeugung dieser hohen Gleichspannungen ist nicht trivial und treibt den schaltungstechnischen Aufwand weiter hoch.

Daher wird hier vorgeschlagen, dass viele Kondensatoreinrichtungen in Serie geschalten werden, um die benötigte Steuergleichspannung auf einem akzeptablen Niveau zu halten.

Bevorzugt werden weiterhin die Steuergleichspannungen so angelegt, dass sich ihre Polarität immer abwechselt und sich so die Spannungen nicht auf ungünstig hohe Werte aufsummieren.

In Figur 6 bedeutet dies, dass beispielsweise von oben nach unten die einzelnen Kondensatoreinrichtungen jeweils wechselweise mit den ihnen zugeordneten Spannungsquellen mit umgekehrten Spannungen beaufschlagt werden. Die Spannungsneutralität der gesamten Kondensatoreirichtung ist unabhängig von dieser Maßnahme immer gegeben, da jede Kondensatoreinheit für sich bereits nach außen hin elektrisch neutral ist und der variable Kondensator immer aus Kondensatoreinheiten aufgebaut wird.

Falls der Kondensator beispielsweise als Parallelkondensator wie in Figur 3b eingesetzt wird, ist die Kondensatoreinheit in der oben beschriebenen Variante mit zwei Anschlussklemmen für den Arbeitswechselstrom gut geeignet. Soll jedoch zum Beispiel der Serienkondensator eines Serienresonanzwandlers als variabler Kondensator ausgeführt sein, kann eine Kondensatoreinheit, wie in Figur 7 gezeigt, besser geeignet sein.

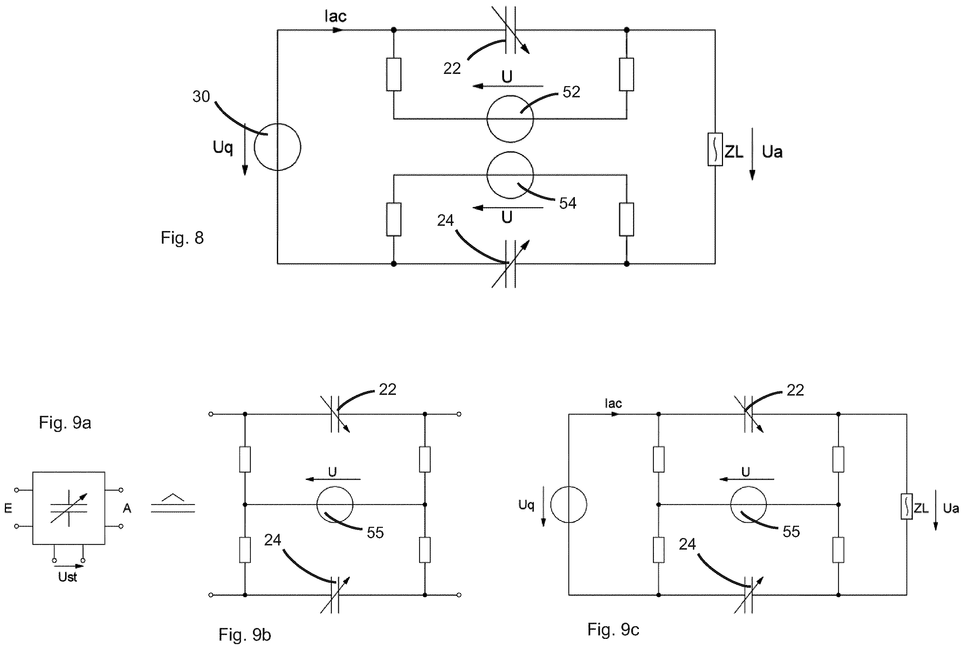

Diese weist hier vier Anschlussklemmen 41, 42, 43 und 44 für den Arbeitswechselstrom auf. Figur 7 zeigt wieder entsprechend rechts ein Schaltbild und links das entsprechende Blockschaltbild mit den vier Anschlussklemmen für den Arbeitswechselstrom und einem Steuereingang (Ust). Eine Kondensatoreinheit mit der in Figur 7 gezeigten Konfiguration kann beispielsweise in den in Figur 8 gezeigten Stromkreis eingebettet sein.

Beim Umlauf der Masche kürzen sich die Steuergleichspannungen, die von den Spannungsquellen 52 und 54 stammen aus der Maschengleichung heraus und sind somit weder am Eingang E noch am Ausgang A (vgl. rechter Teil der Figur 7) wirksam.

Die Figuren 9a und 9b zeigen eine weitere Vereinfachung dieser Situation. Die beiden potenzialgetrennten Spannungsquellen werden hier in einer Spannungsquelle 55 zusammengefasst. Dabei zeigt Figur 9a wieder das Blockschaltbild wie in Fig. 7, Figur 9b das vereinfachte Schaltbild der Kondensatoreinheit nach der oben beschriebenen Art und die Figur 9c die Kondensatoreinheit im Probestromkreis.

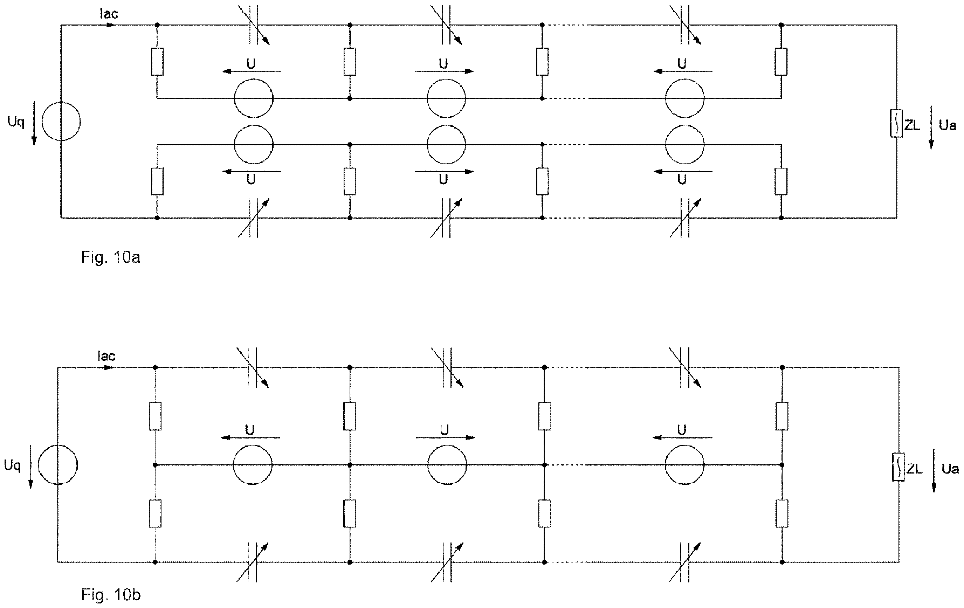

Sowohl mit der Kondensatoreinheit der oben beschriebenen Varianten (Figur 8) als auch mit der vereinfachten Variante (Figur 9) ist für höhere Arbeitswechselströme eine Serienschaltung mehrerer Kondensatoren möglicherweise erforderlich oder vorteilhaft. Analog zur Verschaltung der Kondensatoreinheiten der oben beschriebenen Variante mit der abwechselnden Polarität der Steuergleichspannungen ist auch in Figur 10a, b diese Verschaltung dargestellt. Genauer zeigt Figur 10a eine Darstellung mit jeweils einer Spannungsquelle, die einer einzelnen Kondensatoreinrichtung zugeordnet ist und Figur 10b eine Darstellung, wo eine Spannungsquelle jeweils zwei Kondensatoreinrichtungen zugeordnet ist.

Die Kondensatoreinheit weist jedoch in jeder der oben in den Figuren 10a und 10b gezeigten Ausführungsformen jeweils wieder einen Nachteil auf. In der Ausführung nach Figur 10a ist die doppelte Anzahl von Spannungsquellen nötig als bei der Ausgestaltung von Figur 10b. In der Ausführung von Figur 10b liegt sowohl Uq als auch Ua über jeweils einem Widerstandspaar an. Dies führt zu Strömen, die die Widerstände, welche eigentlich nur zur Steuerung der variablen Kapazität dienen, zusätzlich belasten.

Die Lastimpedanz ZL kann im Falle eines induktiven Übertragungssystems die Sendespule sein. Bei solchen Systemen, die im kW-Bereich arbeiten, liegen in der Regel die Spulenspannungen im kV-Bereich. Das Widerstandspaar, an dem in Abbildung 10a, b die Spannung Ua anliegt, müsste in diesem Fall für die hohe Spannung ausgelegt sein, was einen erheblichen Aufwand bedeutet und deshalb einen schwerwiegenden Nachteil der Schaltungsanordnung darstellt.

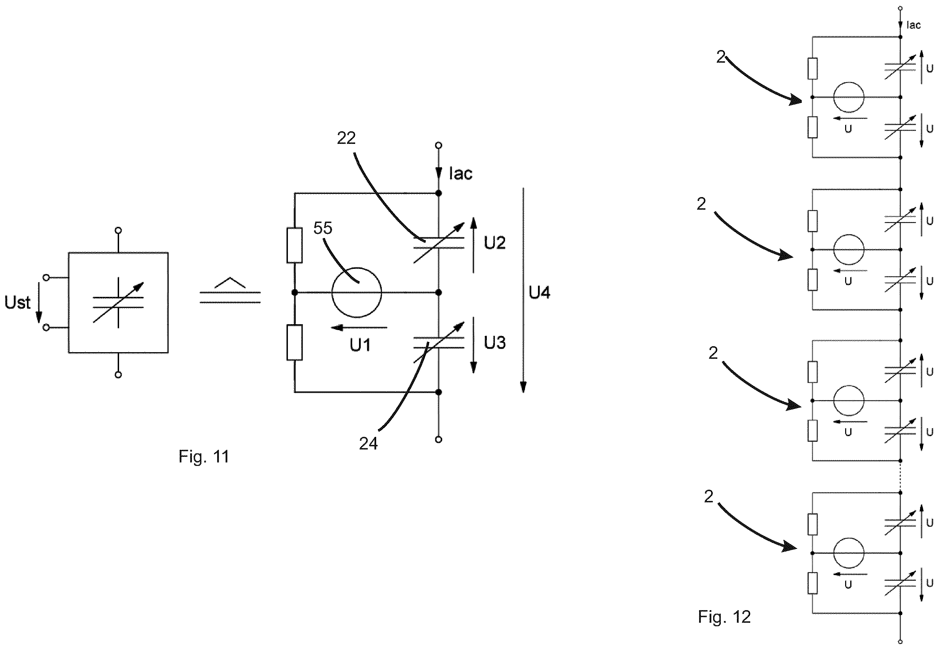

Um diese genannten Nachteile zu vermeiden, wird die Kondensatoreinheit nach Abbildung 11 eingeführt. Diese Schaltungsanordnung kann durch Verschieben der Spannungsquellen der Kondensatorzelle nach Figur 4 über den gemeinsamen Knoten hergeleitet werden.

Ein Vorteil dieser Anordnung der Kondensatoreinheit nach Figur 11 gegenüber der oben beschriebenen Variante von Figur 4 ist die Halbierung der notwendigen Anzahl von Steuergleichspannungsquellen. Darüber hinaus fällt der Nachteil der erforderlichen Gleichheit der Spannungen U1 und U2 der Kondensatoreinheit aus Figur 4 hier weg. Wird die Kondensatoreinheit aus Abbildung 11 betrachtet, so ist es jetzt ausgeschlossen, dass U4 einen Gleichanteil, verursacht durch die Steuerspannung, aufweist.

Figur 12 zeigt entsprechend zur Abbildung 6 eine Serienschaltung von Kondensatoreinheiten der in Figur 11 beschriebenen Variante. Dabei vermeiden auch hier die abwechselnden Polaritäten der Spannungsquellen eine ungünstige Addition der Spannungen im Inneren des variablen Kondensators.

Die Kondensatoreinheit nach der in Figur 11 beschriebenen Variante kann sowohl als Parallel- als auch als Serienkondensator, beispielsweise in einem Parallel- oder Serienresonanzwandler (Figur 3) in der in Figur 11 dargestellten Art und Weise aufgebaut sein und stellt hier eine vorteilhafte Grundstruktur eines spannungssteuerbaren variablen Kondensators dar.

Durch den Polarisationswechsel der über den Kondensatoreinrichtungen anliegenden Steuergleichspannungen U kann zwischen zwei beliebigen Knoten der Schaltung des variablen Kondensators niemals eine höhere Spannung als U auftreten bzw. gemessen werden. Daher kann die Wahl der Steuergleichspannung in Verbindung mit den als variablen Kondensatoren benutzten Bauelementen optimal angepasst werden.

Erst in einem zweiten unabhängigen Designschritt kann die benötigte Anzahl an Kondensatorstellen an die Gesamtwechselspannung angepasst werden, was die Dimensionierung vereinfacht.

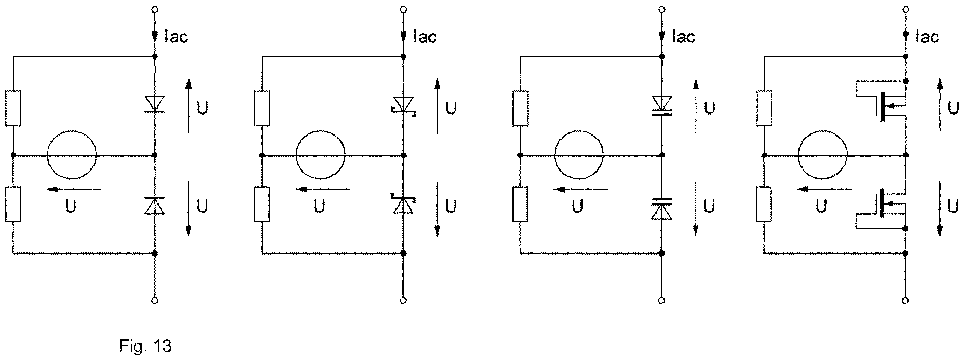

Figur 13 zeigt vier verschiedene Ausführungsformen für Kondensatoreinheiten. Neben den ferroelektrischen Kondensatoren, wie zum Beispiel Keramikkondensatoren (zum Beispiel X7R, X7T) kann die Kondensatoreinrichtung auch mit Hilfe von Varaktordioden, Schottky-Dioden, Mosfets, Thyristoren usw. aufgebaut werden.

Das Prinzip der vorgeschlagenen Spannungsversorgung erlaubt die Nutzung eines beliebigen Bauteils mit spannungsabhängiger Kapazität, welches in der Lage ist, wenigstens unipolar, wie eine Diode, eine Gleichspannung zu sperren.

Figur 13 zeigt mehrere Konfigurationsmöglichkeiten der Kondensatoreinheit bzw. der Kondensatoreinrichtung der oben beschriebenen Variante mit verschiedenen aus der Elektronik bekannten Bauteilen. Da die Steuergleichspannung immer größer als die Wechselspannung ist (Figur 2), befinden sich auch alle Bauelemente mit Diodencharakteristik immer in Sperrrichtung, sodass praktisch kein Gleichstrom, Sperr- und Leckströme ausgenommen, durch die Anordnung fließt.

Die im Rahmen der in der vorliegenden Anmeldung aufgezeigten Schaltungen für Kondensatoreinheiten, Kondensatoreinrichtungen und Gesamtkondensatoren mit variabler Kapazität, stellen eine einfache und an Strom- und Spannungsniveau anpassbare Möglichkeit die Realisierung eines variablen Kondensators dar.

Vor allem die oben nach Figur 11 beschriebene Kondensatoreinheit ist dabei ein sehr einfacher und praktikabler Lösungsansatz. Die Änderungsgeschwindigkeit der variablen Kapazität und die damit verbundene Regelgeschwindigkeit für z. B. Resonanzwandler hängt stark von den Werten der Umladewiderstände bzw. Impedanzen ab, über welche die spannungsabhängigen Kondensatoren auf die Steuergleichspannung aufgeladen werden. Dieser Umstand kann ein Ausschlusskriterium für den Einsatz eines variablen Kondensators nach der hier aufgezeigten Ausführung sein.

Die Wahl der Komponenten bzw. der Bauteile, welche eine spannungsabhängige Kapazität zeigen, bestimmt die realisierbaren elektrischen Größen (U, I, C) und die Verluste. Gerade der Einsatz von ferroelektrischen Kondensatoren erfordert eine genaue Kenntnis der Hysterese- bzw. Polarisierungsverluste.

Die Anmelderin behält sich vor, sämtliche in den Anmeldungsunterlagen offenbarten Merkmale als erfindungswesentlich zu beanspruchen, sofern sie einzeln oder in Kombination gegenüber dem Stand der Technik neu sind. Es wird weiterhin darauf hingewiesen, dass in den einzelnen Figuren auch Merkmale beschrieben wurden, welche für sich genommen vorteilhaft sein können. Der Fachmann erkennt unmittelbar, dass ein bestimmtes in einer Figur beschriebenes Merkmal auch ohne die Übernahme weiterer Merkmale aus dieser Figur vorteilhaft sein kann. Ferner erkennt der Fachmann, dass sich auch Vorteile durch eine Kombination mehrerer in einzelnen oder in unterschiedlichen Figuren gezeigter Merkmale ergeben können.

### Bezugszeichenliste

- 6, 26: Spule
- 10: Spannungsquelle
- 14a: Schalteinrichtung
- 14b: Schalteinrichtung
- 20: Kondensatoreinheit
- 22, 24: Kondensatoreinrichtung
- 25a, 25b, 25c: Ausgleichswiderstand
- 32, 34, 36: Widerstand
- 41, 42, 43,44: Anschlussklemme
- 50: induktive Energieübertragungsvorrichtung bzw. Resonanzwandler
- 52, 54: Spannungsquelle
- 100: Halbbrücken-Serienresonanzwandler
- 102: Kondensatoreinrichtung
- C(U): Kapazitätsverlauf eines Kondensators als Funktion der angelegten Spannung U
- C1,C2: Kapazität
- C1_avg: mittlerer Kapazitätswert
- C2_avg: mittlerer Kapazitätswert
- Iac(s): komplexer Arbeitsstrom, komplexer Arbeitswechselstrom
- R1, R2, R3: ohmscher Widerstand
- τ: Zeitkonstante
- U: Spannung
- U1, U2: Gleichspannung
- U3, U4, U5: Gleichspannung
- UA: Spannung
- Uac(s): komplexe Wechselspannung
- uC(t): Spannungszeitverlauf
- Udc1, Udc2: DC-Vorspannung
- Uq: Quellenspannung
- ZL: Lastimpedanz
- Z(s): Impedanz

## Patentansprüche

1. Schaltungsanordnung, für eine induktive Energieübertragungsvorrichtung (50) mit einer Spuleneinrichtung (6), welche zur Ausgabe eines elektromagnetischen Feldes dient und mit einer Wechselspannungserzeugungseinrichtung (10, 14a, 14b), welche eine Wechselspannung erzeugt, mit der die Spuleneinrichtung (6) versorgbar ist, wobei die Schaltungsanordnung wenigstens eine Kondensatoreinheit (20) mit variabler Kapazität aufweist,
**dadurch gekennzeichnet, dass**
die Kondensatoreinheit (20) wenigstens eine erste Kondensatoreinrichtung (22) mit variabler Kapazität (C1) und eine zweite Kondensatoreinrichtung (24) mit variabler Kapazität (C2) aufweist wobei die erste Kondensatoreinrichtung (22) wenigstens zeitweise mit einer ersten Steuerspannung (U1) beaufschlagt ist und der zweite Kondensatoreinrichtung (24) wenigstens zeitweise mit einer zweiten Steuerspannung (U2) beaufschlagt ist.

2. Schaltungsanordnung (1) nach Anspruch 1,
**dadurch gekennzeichnet, dass**
die erste Kondensatoreinrichtung (22) und die zweite Kondensatoreinrichtung (24) in Serie geschalten sind.

3. Schaltungsanordnung (1) nach wenigstens einem der vorangegangenen Ansprüche, **dadurch gekennzeichnet, dass**
die erste Steuerspannung (U1) und die zweite Steuerspannung (U2) gegensinnig zueinander an den Kondensatoreinrichtungen (22, 24) angelegt sind.

4. Schaltungsanordnung (1) nach wenigstens einem der vorangegangenen Ansprüche, **dadurch gekennzeichnet, dass**
die Kondensatoreinheit (20) wenigstens zwei elektrische Anschlüsse (42, 44) aufweist und bevorzugt hinsichtlich dieser elektrischen Anschlüsse (42, 44) als elektrisch neutrale und insbesondere spannungslose Einheit wirkt.

5. Schaltungsanordnung (1) nach wenigstens einem der vorangegangenen Ansprüche, **dadurch gekennzeichnet, dass**
die Schaltungsanordnung (1) wenigstens eine Spannungsquelle (52, 54) zur Bereitstellung der Steuerspannungen (U1, U2) aufweist, wobei diese wenigstens eine Spannungsquelle (52, 54) die Steuerspannungen bevorzugt gegengleich an die Kondensatoreinrichtungen (C1, C2) zur Verfügung stellt.

6. Schaltungsanordnung (1) nach wenigstens einem der vorangegangenen Ansprüche, **dadurch gekennzeichnet, dass**
die Schaltungsanordnung mehrere Kondensatoreinheiten (20) mit variabler Kapazität aufweist.

7. Schaltungsanordnung (1) nach dem vorangegangenen Anspruch,
**dadurch gekennzeichnet, dass**
jede der Kondensatoreinheiten wenigstens eine dieser zugeordneten Spannungsquellen aufweist.

8. Schaltungsanordnung (1) nach Anspruch 5,
**dadurch gekennzeichnet. dass**
die Schaltungsanordnung genau eine Spannungsquelle (18) zur Bereitstellung der Steuerspannungen (U1, U2) aufweist.

9. Schaltungsanordnung nach dem vorangegangenen Anspruch,
**dadurch gekennzeichnet, dass**
die Spannungsquelle über einen ersten Knotenpunkt (18) mit beiden Kondensatoreinrichtungen (22, 24) verbunden ist.

10. Schaltungsanordnung (1) nach wenigstens einem der vorangegangenen Ansprüche, **dadurch gekennzeichnet, dass**
die Kondensatoreinrichtung aus einer Gruppe von Kondensatoreinrichtungen ausgewählt ist, welche Keramikkondensatoren, insbesondere X7R und X7T, VaraktorDioden, Schottky-Dioden, Mosfets, Thyristoren und dergleichen enthält.

11. Anordnung zum induktiven Laden von Kraftfahrzeugen mit einer ersten Schaltanordnung, welche eine Sendespule zum Ausgeben eines elektromagnetischen Feldes aufweist sowie einer zweiten Schaltanordnung, welche eine Empfangspule aufweist, um das von der Sendespule ausgegebene Signal aufzunehmen, wobei die Schaltanordnung eine Schaltanordnung nach wenigstens einem der vorangegangenen Ansprüche ist.

12. Kondensatoreinheit (20) insbesondere zur Anwendung in induktiven Ladesystemen, **dadurch gekennzeichnet, dass**
die Kondensatoreinheit (20) wenigstens eine erste Kondensatoreinrichtung (22) mit variabler Kapazität (C1) und eine zweite Kondensatoreinrichtung (24) mit variabler Kapazität (C2) aufweist wobei die erste Kondensatoreinrichtung (22) wenigstens zeitweise mit einer ersten Steuerspannung (U1) beaufschlagt ist und die zweite Kondensatoreinrichtung (24) wenigstens zeitweise mit einer zweiten Steuerspannung (U2) beaufschlagt ist, wobei die erste Kondensatoreinrichtung (22) und die zweite Kondensatoreinrichtung (24) in Serie geschalten sind und bevorzugt die erste Steuerspannung (U1) und die zweite Steuerspannung (U2) gegensinnig zueinander an den ihnen zugeordneten Kondensatoren (22, 24) angelegt sind.

13. Verfahren zum Betreiben einer induktiven Energieübertragungsanordnung, wobei mittels einer Sendespule auf eine Empfangsspule elektrische Energie übertragen wird und wobei eine Schaltungsanordnung mit einem Spannungssignal beaufschlagt wird um die Sendespule mit einer Wechselspannung zu beaufschlagen und wobei die der Sendespule zugeführte Wechselspannung mittels wenigstens einer Kondenensatoreinheit (20) gesteuert wird, deren Kapazität verändert wird,
**dadurch gekennzeichnet, dass**
die Kondensatoreinheit wenigstens eine erste Kondensatoreinrichtung (22) mit einer veränderbaren Kapazität und eine zweite Kondensatoreinrichtung (24) mit einer veränderbaren Kapazität aufweist und die erste Kondensatoreinrichtung (22) mit einer ersten Steuerspannung (U1) beaufschlagt wird und die zweite Kondensatoreinrichtung (24) mit einer zweiten Steuerspannung (U2) beaufschlagt wird.

14. Verfahren nach Anspruch 13,
**dadurch gekennzeichnet, dass**
die erste Kondensatoreinrichtung (22) und die zweite Kondensatoreinrichtung (24) in Serie geschaltet werden.

15. Verfahren nach Anspruch 13 oder 14,
**dadurch gekennzeichnet, dass**
die erste Kondensatoreinrichtung (22) und die zweite Kondensatoreinrichtung (24) gegensinnig mit den Steuerspannungen beaufschlagt werden.
